# EUROPEAN PATENT APPLICATION

(11) **EP 4 618 702 A1**
(43) Date of publication of application: **17.09.2025**
(21) Application number: 23887528.0
(22) Date of filing: 20.07.2023
(51) Int. Cl.: H05K 5/02

(54) **DECORATIVE PLATE, COVER PLATE, AND ELECTRONIC DEVICE**

(30) Priority: 08.11.2022 CN 202211392400
(71) Applicant: BYD Company Limited, Shenzhen, Guangdong 518118 (CN)
(72) Inventor: YUAN, Sun, Shenzhen, Guangdong 518118 (CN); LUO, Wenhai, Shenzhen, Guangdong 518118 (CN); ZHAO, Lihong, Shenzhen, Guangdong 518118 (CN); DUAN, Feifei, Shenzhen, Guangdong 518118 (CN); ZHAO, Fei, Shenzhen, Guangdong 518118 (CN)
(74) Representative: Mathys & Squire
(86) International application number: PCT/CN2023/108426
(87) International publication number: WO 2024/098832

(57) **Abstract**

An electronic device, comprising a cover plate provided with a decorative plate. The decorative plate comprises a substrate and a texture layer provided on the substrate. The texture layer comprises multiple texture units. The multiple texture units comprise multiple first linear textures spaced apart in a first direction, and each first lineal texture comprises, in an extension direction thereof, multiple connected first lineal texture sub-segments. The multiple first linear texture sub-segments are bent in the same direction in the plane where the texture layer is located, and the bending direction is different from the extension direction of the first lineal textures. The extension direction of the first lineal textures is different from the first direction.

## Description

The present disclosure claims priority to Chinese Patent Application No. 202211392400.2 filed on November 08, 2022 and titled " Decorative PLATE, COVER PLATE AND ELECTRONIC DEVICE", which is incorporated herein by reference in its entirety.

### FIELD

The present disclosure relates to the field of decoration, and in particular, to decorative plate, cover plate, and electronic device.

### BACKGROUND

In the related art, the texture of an electronic device appearance decoration is relatively monotonous, and the appearance expression is insufficient, especially the change of light and shadow effects is monotonous, which fails to meet the needs of consumers. The industry often solves the above problems by simply changing the arrangement direction of the texture, the flow pattern of the texture or superimposing two different textures. However, current superimposed textures are mostly simple superposition of two groups of strip textures with convex or concave structures, which are interwoven to form two groups of different continuous light and shadow effects. Not only are the overall light and shadow effects still relatively monotonous, but also Moiré patterns are prone to appearing, which seriously affect the appearance.

### SUMMARY

In view of this, the present disclosure provides a decorative plate, the surface of which is provided with a special micro-nano texture structure, which allows light and shadow to flow within each texture unit when the user changes the viewing angle, and the three-dimensional effect is pronounced, thereby exhibiting a good decorative effect.

Specifically, the first aspect of the present disclosure provides a decorative plate, including a substrate and a texture layer arranged on the substrate; wherein the texture layer includes multiple texture units, the multiple texture units include multiple first linear textures spaced apart in a first direction, each first linear texture includes, in an extension direction thereof, connected multiple first linear texture sub-segments, the multiple first linear texture sub-segments are bent in the same direction in a plane where the texture layer is located, and the bending direction is different from the extension direction of the first linear texture; the extension direction of the first linear texture is different from the first direction.

Each first linear texture sub-segment is bent in the same direction in the plane where the texture layer is located to present a curved shape, which results in different reflection and scattering abilities of the first linear texture sub-segment towards the same light source at different positions, Therefore, the light and shadow effects at different positions of the first linear texture sub-segment are different; and within the single first linear texture, the light and shadow can also exhibit a flow effect in the extension direction of the first linear texture. The interior of each texture unit is provided with first linear textures spaced apart in the first direction, so that the superposition effect makes each texture unit display a clear effect of light and shadow flowing in the first direction, and after the multiple texture units are superimposed, the decorative plate can display a gorgeous light and shadow effect, with rich texture, high visual recognition and less prone to Moiré patterns .

A second aspect of the present disclosure provides a cover plate, including the decorative plate and the substrate provided in the first aspect of the present disclosure, wherein the decorative plate is arranged on the surface of the substrate.

A third aspect of the present disclosure provides an electronic device, including the cover plate provided in the second aspect of the present disclosure.

### BRIEF DESCRIPTION OF THE DRAWINGS

FIG. 1 is a schematic diagram of a cross-sectional structure of the decorative plate according to an embodiment of the present disclosure.
FIG. 2A is a top view schematic diagram of the texture unit in the decorative plate according to an embodiment of the present disclosure.
FIG. 2B is a top view schematic diagram of interior structure of the same texture unit observed from different perspectives in the decorative plate provided in an embodiment of the present disclosure;
FIG. 2C is a top view schematic diagram of the texture unit with the first thin light column in the decorative plate according to an embodiment of the present disclosure.
FIG. 3 is a top view schematic diagram of the first linear texture in an embodiment of the present disclosure;
FIG. 4A is a gray scale diagram of the first linear texture sub-segment according to an embodiment of the present disclosure.
FIG. 4B is a cross-sectional view of the first linear texture sub-segment according to an embodiment of the present disclosure;
FIG. 4C is a top view of the first linear texture provided with the strip texture on the surface thereof in the decorative plate according to an embodiment of the present disclosure;
FIG. 4D is a front view of the first linear texture provided with the strip texture on the surface thereof in the decorative plate according to an embodiment of the present disclosure;
FIG. 4E is a right side view of the first linear texture provided with the strip texture on the surface thereof in the decorative plate according to an embodiment of the present disclosure;
FIG. 5A is a top view schematic diagram of the texture unit in the decorative plate according to another embodiment of the present disclosure.
FIG. 5B is an enlarged view of a partial area of FIG. 5A;
FIG. 6A is a top view schematic diagram of the second linear texture according to an embodiment of the present disclosure.
FIG. 6B is a top view schematic diagram of the second linear texture within the texture unit provided with the second thin light column according to an embodiment of the present disclosure.
FIGS. 7A-7B are partial enlarged views of the texture unit in the decorative plate according to another embodiment of the present disclosure;
FIG. 8A is a top view schematic diagram of the texture unit in the decorative plate according to an embodiment of the present disclosure.
FIG. 8B is a top view schematic diagram of another texture unit in the decorative plate according to an embodiment of the present disclosure.
FIG. 9A is a top view schematic diagram of another texture unit in the decorative plate according to another embodiment of the present disclosure.
FIG. 9B is an enlarged view of a partial area of FIG. 9A;
FIG. 10 is a top view schematic diagram of another texture unit in the decorative plate according to an embodiment of the present disclosure.
FIG. 11 is a top view schematic diagram of the decorative plate according to an embodiment of the present disclosure.

Description of reference numbers: 100-decorative plate; 10-substrate 20-texture layer; 21- texture unit; 22- first linear texture; 221- first linear texture sub-segment; 2211-strip texture; 23- second linear texture; 231-second linear texture sub-segment.

### DETAILED DESCRIPTION

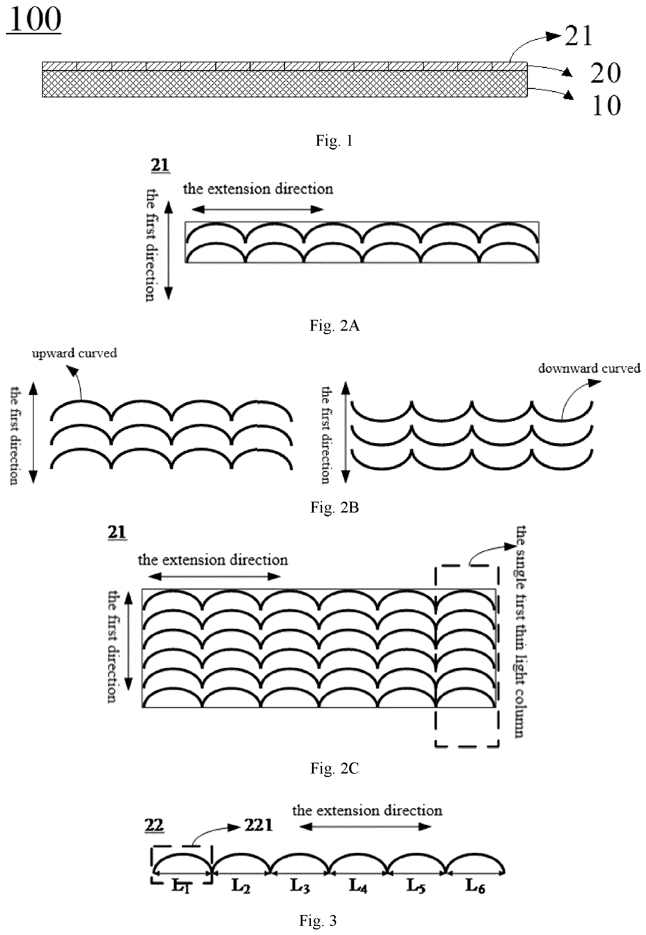

An embodiment of the present disclosure provides a decorative plate 100, including a substrate 10 and a texture layer 20 arranged on the substrate 10; wherein the texture layer 20 includes multiple texture units 21. Referring to FIG. 1, the texture units 21 include multiple first linear textures 22 spaced apart in a first direction, and the multiple first linear textures 22 are preferably spaced apart in parallel. Referring to FIGS. 2A-2B and FIG 3, each first linear texture 22 includes, in an extension direction thereof, multiple connected first linear texture sub-segments 221, and the multiple first linear texture sub-segments 221 are connected end to end. The multiple first linear texture sub-segments 221 are bent in the same direction in the plane where the texture layer 20 is located, and the bending direction is different from the extension direction of the first linear texture 22; the extension direction of the first linear texture 22 is different from the first direction.

The first linear texture sub-segment 221 is bent in the plane where the texture layer 20 is located, and at this time, each first linear texture sub-segment 221 is "lying flat" on the substrate 10. The multiple first linear texture sub-segments 221 are bent in the same direction, so that a single first linear texture 22 includes multiple curved first linear texture sub-segments connected end to end. For example, the first linear texture sub-segment 221 mentioned above can be arc-shaped, parabolic-shaped, arched-shaped, etc. It should be noted that in the present disclosure, each first linear texture sub-segment 221 in the single texture unit 21 is bent in the same direction, which means that the bending direction of the each first linear texture sub-segment 221 is the same, taking the starting point of the first linear texture 22 as the origin, and the extension direction as the positive half-axis of the x-axis, a Cartesian coordinate system is established with the direction perpendicular to the x-axis in the texture layer 20 as the y-axis, so that each linear texture sub-segments 221 in the single first linear texture 22 is bent in the first quadrant or the fourth quadrant of the xOy coordinate system. Under this general premise, the relative positions of the orthographic projections of the highest point of curvature of each first linear texture sub-segment 221 on the line connecting its head end and tail end may be the same or different. It can be understood that the bending directions of the first linear texture sub-segments 221 of different texture units 21 may be the same or different.

The extension direction of the first linear texture 22 is different from the first direction, specifically, the direction of the connecting line between the head end and tail end of the single first linear texture 22 is different from the first direction. In some specific embodiments, the extension direction of the first linear texture 22 is perpendicular or approximately perpendicular to the first direction, and approximately perpendicular specifically means that the angle between the two may be in the range of 80 ° to 100 °. It should be noted that the "first direction" mentioned above is relative to the single texture unit 21, and the first direction of different texture units 21 may be the same or different.

In some embodiments of the present disclosure, in the first direction, continuous multiple adjacent first linear texture sub-segments 221 form a single first thin light column. The interior of the texture unit 21 is provided with first linear textures 22 spaced apart in the first direction, and continuous multiple adjacent first linear texture sub-segments 221 with the same bending direction can form the single first thin light column (see FIG. 2C), and when natural light is irradiated and the decorative plate 100 is slightly swung, the light and shadow can flow in the single first thin light column. The interior of each texture unit 21 is further provided with multiple first thin light columns continuously arranged in the extension direction of the first linear texture 22 without intervals, such a superimposed effect makes each texture unit 21 exhibit a clear effect of the light and shadow flowing in the first direction, and after the multiple texture units 21 are superimposed, the decorative plate 100 exhibits a gorgeous light and shadow effect, with rich texture and high visual recognition.

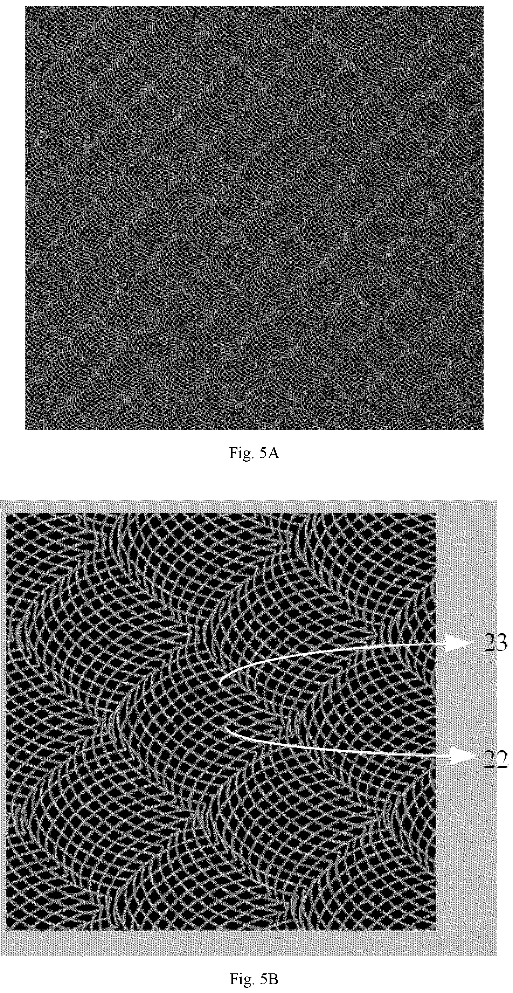

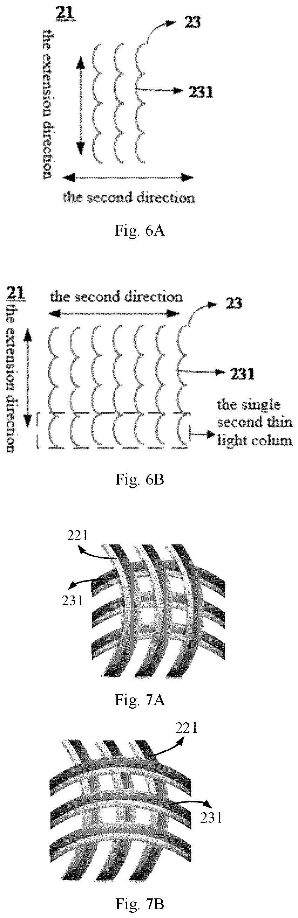

In some embodiments of the present disclosure, the texture unit further includes multiple second linear textures 23 spaced apart in the second direction (see FIGS. 5A-5B). Referring to FIG. 6A, each second linear texture 23 includes, in an extension direction thereof, multiple connected second linear texture sub-segments 231, the multiple second linear texture sub-segments 231 are connected end to end, the multiple second linear texture sub-segments 231 are bent in the same direction in the plane where the texture layer 20 is located, and the bending direction is different from the extension direction of the second linear texture 23; the extension direction of the second linear texture 23 is different from the second direction, wherein, the extension direction of the second linear texture 23 is a direction where the connecting line of the head end and tail end of the second linear texture 23 is located. The internal structure of the second linear texture 23 is similar to the internal structure of the first linear texture 22, and will not be repeated here. Preferably, within a single texture unit 21, the second linear texture 23 is arranged at parallel intervals in the second direction. Within the second linear texture 23, the "curvature" of the curved shape of the second linear texture sub-segment 231 may be the same as or different from that of the first linear texture sub-segment 221. If the extension direction and the arrangement direction of the first linear texture 22 and the second linear texture 23 are different, then each first linear texture sub-segment 221 will intersect with at least one second linear texture sub-segment 231, and each second linear texture sub-segment 231 will also intersect with at least one first linear texture sub-segment 221, so that the texture layer 20 has a pattern superposition effect of the two textures. Because the extension direction and arrangement direction of the two linear textures are different, there must be some differences in the refraction and reflection effects of the same light source, not to mention the different flow directions of the light and shadow within the two texture structures. Therefore, the decorative plate 100 can present a cool effect of superimposed changes of the light and shadow of the two textures, and better avoid the homogenization of appearance.

When the first linear texture sub-segment 221 and the second linear texture sub-segment 231 intersect, it can be understood that the intersection of the first linear texture sub-segment 221 and the second linear texture sub-segment 231 is not interrupted, but superimposing the two linear textures at the intersection, and the adaptation processing is performed to ensure the original outer contour of the first linear texture sub-segment 221 or the second linear texture sub-segment 231 remains unchanged. For example, both the first linear texture sub-segment 221 and the second linear texture sub-segment 231 are solid objects with a certain height, and assuming that they are respectively placed in a three-dimensional coordinate system, the coordinates of any point on the outer surface of the first linear texture sub-segment 221 are (x, y, z), the coordinates of any point on the outer surface of the second linear texture sub-segment 231 are (a, b, c), when x = a and y = b, if z > c, the final height of the linear texture is z at the intersection (x, y) of the two, at this time, the intersection is connected with the outline of the first linear texture sub-segment 221, forming a complete first linear texture sub-segment 221, the second linear texture sub-segment 231 is fused into the first linear texture sub-segment 221 (see FIG. 7A); if when c > z , x = a and y = b, the final height of the linear texture is c at the intersection (x, y) of the two, similarly, the intersection is in connection with the outline of the second linear texture sub-segment 231, forming a complete second linear texture sub-segment 231 in which the first linear texture sub-segment 221 is fused (see FIG. 7B). If when x = a, y = b and c = z, it can be arbitrarily selected. Those skilled in the art can also adopt other treatment methods to achieve the effects of the present disclosure. Benefiting from the superposition treatment, the decorative plate 100 provided by the present disclosure is less prone to Moiré patterns, has good integrity of textures, without a sense of fragmentation caused by simple superposition of two textures, and has good visual recognition and aesthetic appeal.

In some embodiments of the present disclosure, in the second direction, continuous multiple adjacent second linear texture sub-segments 231 form a single second thin light column (see FIG. 6B). At this time, the interior of texture unit 21 is provided with multiple first thin light column and multiple second thin light column arranged in an intersecting manner, and at this time, the light and shadow flowing effect of the decorative plate 100 is more diverse.

In some embodiments of the present disclosure, the first linear texture sub-segment 221 is bent in the first direction. The first linear texture sub-segments 221 is bent in the first direction, that is, each first linear texture sub-segment 221 lies on the substrate 10, and the most obvious direction of the light and shadow flow within the single first thin light column is also parallel to the first direction. At this time, the decorative plate 100 has a more industrial aesthetic feeling. Specifically, referring to FIG. 2B, the first linear texture sub-segment 221 is bent in the first direction, which may be "upward curved" relative to the first direction or "downward curved" relative to the first direction, depending on the viewing angle of the user. Of course, the above changes also apply when each texture unit 2l is only provided with the first linear texture 22 inside.

In a case where the texture unit 21 further includes the second linear texture 23, in some embodiments of the present disclosure, the second linear texture sub-segment 231 is bent in the second direction. That is, each second linear texture sub-segment 231 lies on the substrate 10, and the most obvious direction of the light and shadow flow within the single second thin light column is also parallel to the second direction. Further, the second linear texture sub-segment 231 may be "upward curved" relative to the second direction or may be "downward curved" relative to the second direction. In some specific embodiments, it is preferable that the first linear texture sub-segment 221 is bent in the first direction and the second linear texture sub-segment 231 is bent in the second direction. At this time, after the two textures are superimposed, the arrangement is more regular, and the flowing rhythm of the light and shadow on the surface of the decorative plate 100 is stronger, with a strong industrial aesthetic.

In some embodiments of the present disclosure, the first linear texture 22 presents a wavy curve. In some embodiments, the second linear texture presents wavy curve when there is the second linear texture 23. In some embodiments, each first linear texture 22 presents wavy curve and each second linear texture 23 presents wavy curve within the single texture unit 21. At this time, in the extension direction of the first and second linear texture, the light and shadow flowing effect in the wave shape can be presented.

In some embodiments of the present disclosure, the angle between the extension direction of the first linear texture 22 and the extension direction of the second linear texture 23 is in the range of 80 ° to 100 °. For example, the above angle may be 80 °, 85 °, 86 °, 87 °, 88 °, 89 °, 90 °, 91 °, 92 °, 93 °, 94 °, 95 °, 100 °, etc. The extension direction of the first linear texture 22 refers to the direction of a line connecting the head end of the first linear texture sub-segment 221 and the tail end of the last first linear texture sub-segment 221 within the first linear texture 22; the extension direction of the second linear texture 23 is similar and will not be repeated here. At this time, the superposition effect of the first linear texture 22 and the second linear texture 23 is more obvious, and it is more effective in avoiding the generation of Moiré patterns.

In the present disclosure, the cross-sectional shape of each linear texture sub-segment can be a triangle, an arch, an arc, a trapezoid, etc, and the cross-sectional width of each linear texture sub-segment gradually decreases from the substrate 10 in the height direction thereof.

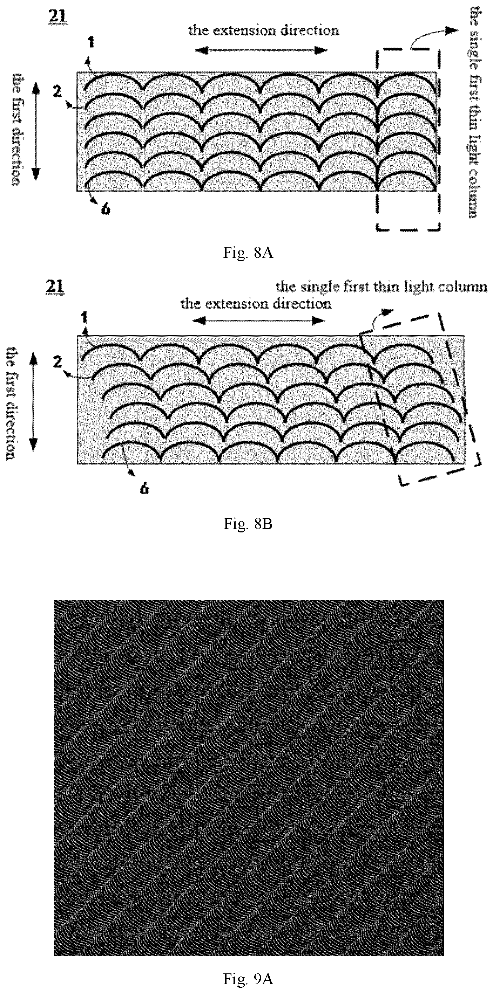

In some embodiments of the present disclosure, some of the continuous multiple first linear textures 22 arranged in the first direction, the multiple first linear texture sub-segments 221 of the multiple first linear textures 22 are spaced apart in the first direction, and adjacent end points of the multiple first linear texture sub-segments 221 arranged in the first direction are connected to form a straight line or a curve. Some of the continuous multiple second linear textures 23 arranged in the second direction, the multiple second linear texture sub-segments 231 of the multiple second linear textures 23 are spaced apart in the second direction, and adjacent end points of the multiple second linear texture sub-segments 231 arranged in the second direction are connected to form a straight line or a curve. Referring to FIG. 8A, taking the first linear texture as an example, the line connecting the end points of the multiple first linear texture sub-segments 221 adjacent in the first direction is the straight line, this refers to the line connecting the head end of the first linear texture sub-segment 1, the first linear texture sub-segment 2, ..., and the first linear texture sub-segment 6 is the straight line, and the line connecting the tail end of the first linear texture sub-segment 1, the first linear texture sub-segment 2, ..., and the first linear texture sub-segment 6 is also a straight line, and this law is also maintained for the other first linear texture sub segments 221 within the first linear texture 22. Referring to FIG. 8B, the line connecting the end points of the multiple first linear texture sub-segments 221 adjacent in the first direction is the curve, this refers to the line connecting the head end of the first linear texture sub-segment 1, the first linear texture sub-segment 2, ..., and the first linear texture sub-segment 6 is the curve, and the line connecting the tail end of the first linear texture sub-segment 1, the first linear texture sub-segment 2, ..., and the first linear texture sub-segment 6 is also the curve, and this law is also maintained for the other first linear texture sub-segments 221 within the first linear texture 22. It can also be understood that the first linear textures 22 arranged in the first direction are displaced between each other. The curve may be an arc shape, a parabola shape, a wave shape, etc. At this time, the moving line of light in the single first thin light column is also curved, and the appearance is more diverse, which is conducive to presenting a sparkling feeling. Similarly, similar structural adjustment may be made to the second linear texture 23, which will not be described herein. In some specific embodiments, within the single texture unit 21, the first linear texture 22 in the first direction, the second linear texture 23 in the second direction is arranged in a straight line or in a curved line; in other embodiments, one of the first linear textures 22 in the first direction and the second linear texture 23 in the second direction is arranged in a straight line and the other is arranged in a curved line. In the present disclosure, the decorative plate 100 includes multiple texture units 21, and the conditions within the multiple texture units 21 can be the same or different, and can be the combination of the above conditions, and those skilled in the art can design according to actual needs. Of course, the above changes also apply when each texture unit is only provided with the first linear texture 22 inside.

In some embodiments of the present disclosure, the maximum distance from the first linear texture sub-segment 221 and the second linear texture sub-segment 231 to the substrate 10 is each independently in the range of 0.5 µm to 20 µm. For example, the maximum distance from the first linear texture sub-segment 221, the second linear texture sub-segment 231 to the substrate 10 may each independently be 0.5 µm, 0.6 µm, 0.7 µm, 0.8 µm, 0.9 µm, 1.0 µm, 2 µm, 5 µm, 10 µm, 15 µm, 20 µm, etc. Referring to FIGS. 1, 3, and 4B, taking the first linear texture sub-segment 221 as an example, the maximum distance thereof to the substrate 10 refers to the absolute height h from the lowest point of the contour of the first linear texture 22 to the highest point of the contour thereof. Referring to FIGS. 1, 3, and 4A to 4E, the maximum distance from the first linear texture sub-segment 221 to the substrate 10 can also be understood as the maximum distance h from the highest point of the cross section to the bottom line of the cross section obtained by cutting the first linear texture sub-segment 221 with a plane perpendicular to the substrate 10 and the extension direction of the first linear texture sub-segment 221. Of course, the above changes also apply when each texture unit 21 is only provided with the first linear texture 22 inside.

In some embodiments of the present disclosure, in at least part of the texture units 21, the maximum distance from each first linear texture sub-segment 221 to the substrate 10 gradually changes in the extension direction of the first linear texture 22; and/or the maximum distance from each second linear texture sub-segment 231 to the substrate 10 gradually changes in the extension direction of the second linear texture 23. The above gradual change specifically means that the maximum distance from the single first and second linear texture sub-segment 231 to the substrate 10 is the same, but the maximum distance from multiple adjacent first linear texture sub-segments 221 to the substrate 10 gradually increases or gradually decreases; the maximum distance change from the second linear texture 23 to the substrate 10 also follows the above principle, and will not be described herein. In some specific embodiments, the maximum distance from the first linear texture sub-segment 221 to the substrate 10 gradually changes in the extension direction thereof, and the maximum distance from the second linear texture sub-segment 231 to the substrate 10 is unchanged; in other specific embodiments, the maximum distance from the second linear texture sub-segment 231 to the substrate 10 gradually changes in the extension direction thereof, and the maximum distance from the first linear texture sub-segment 221 to the substrate 10 is unchanged; in still other embodiments, the maximum distance from the first and second linear texture to the substrate 10 may be changed or unchanged. Of course, when each texture unit 21 is only provided with the first linear texture 22 inside, the maximum distance from the first linear texture 22 to the substrate 10 may gradually change in the extension direction thereof.

In some embodiments of the present disclosure, in at least part of the texture units 21, the maximum distance from the multiple first linear textures 22 to the substrate 10 gradually changes in the first direction; and/or the maximum distance from the multiple second linear textures 23 to the substrate 10 gradually changes in the second direction. In other words, within the single first and/or second thin light column, the maximum distance from each linear texture sub-segment to the substrate 10 gradually increases or gradually decreases. Of course, the above changes also apply when each texture unit 21 is only provided with the first linear texture 22 inside.

In some embodiments of the present disclosure, in at least part of the texture units 21, the maximum distance from the multiple first linear texture sub-segments 221 to the substrate 10 gradually increases first and then gradually decreases in the extension direction of the first linear texture sub-segments 221, or gradually decreases first and then gradually increases. And/or the maximum distance from the multiple second linear texture sub-segments 231 to the substrate 10 gradually increases first and then gradually decreases in the extension direction of the second linear texture sub-segment 231, or gradually decreases first and then gradually increases. It can be understood that each linear texture sub-segment presents a larger maximum distance from the middle portion to the substrate 10 (the middle portion of the linear texture sub-segment is convex in the direction away from the substrate 10 and in the thickness direction of the substrate 10), or the maximum distance from both ends to the substrate 10 is larger, so that the visual effect that each linear texture sub-segment is "standing" on the substrate 10 can be presented, and the decorative plate 100 has a more three-dimensional appearance overall.

In some specific embodiments, in at least part of the texture units 21, the maximum distance change trend of the first linear texture 22 and the second linear texture 23 to the substrate 10 is a combination of the above two variation modes, that is, it gradually changes not only with the extension direction of the first linear texture 22 and the second linear texture 23, but also gradually changes in the first or second direction. At this time, the light and shadow changes of the decorative plate 100 are more brilliant. Further, on the basis of the above two changes, the above-described height change is superimposed on the single first and second linear texture sub-segments, and at this time, the pattern on the surface of the decorative plate 100 is rich in three-dimensional effect.

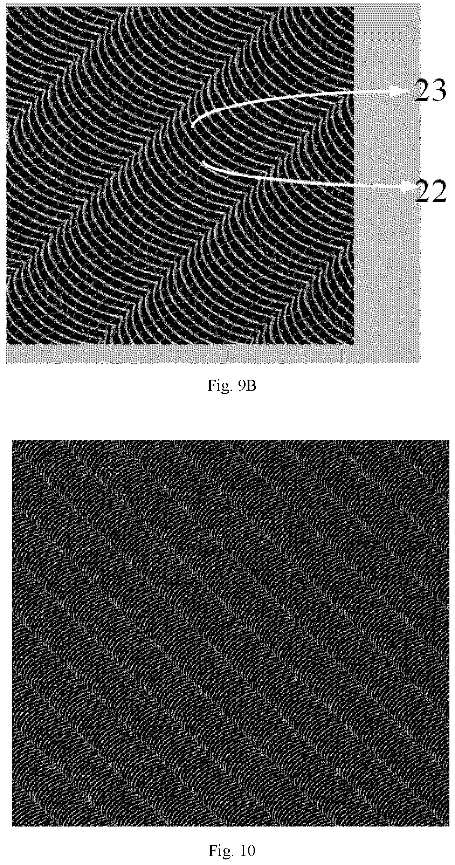

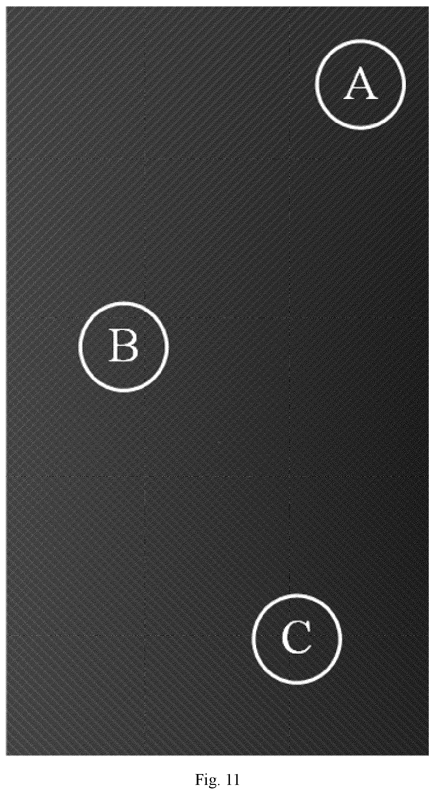

In some embodiments of the present disclosure, referring to FIGS. 9A to 9B, the maximum distance from the first linear texture 22 and the second linear texture 23 to the substrate 10 within the single texture unit 21 of at least part of the texture units 21 is different. The larger the maximum distance from the linear texture to the substrate 10, the more obvious the light and shadow effect of the single thin light column is. In some embodiments, within the single texture unit 21, the maximum distance from all of the first linear textures 22 to the substrate 10 is greater than the maximum distance from all of the second linear textures 23 to the substrate 10. At this time, the light and shadow effect of the first linear texture 22 (first thin light column) is more obvious than that of the second thin linear texture. In other embodiments, it may also be that the maximum distance from the first linear texture 22 within the intersecting first and second thin light columns to the substrate 10 is much greater than the maximum distance from the second linear texture 23 to the substrate 10. It works the other way around as well. In some specific embodiments, the texture layer may have the following three kinds of texture units 21 at the same time: (1) the maximum distance from the first linear texture and the second linear texture to the substrate 10 is close (FIGS. 5A to 5B, corresponding to the B area in FIG. 11); (2) the maximum distance from the first linear texture to the substrate 10 is much larger than the maximum distance from the second linear texture to the substrate 10 (FIGS. 9A to 9B, corresponding to the A area in FIG. 11), and the resulting decorative plate is shown in FIG. 11; (3) the maximum distance from the first linear texture to the substrate 10 is much smaller than the maximum distance from the second linear texture to the substrate 10 (FIG. 10, corresponding to the C area in FIG. 11).

In some embodiments of the present disclosure, the texture layer 20 includes multiple first-level areas, and the multiple first-level areas present different light and shadow changes. At least some first-level areas include at least texture units 21, the extension direction of the first linear texture 22 between the multiple first-level areas is different and/or the extension direction of the second linear texture 23 between the multiple first-level areas is different; and/or the maximum distance from the first linear texture 22 to the substrate 10 between the multiple first-level areas and/or the maximum distance from the second linear texture 23 to the substrate 10 is different.

The extension direction of the first linear texture 22 between the multiple first-level areas is different and/or the extension direction of the second linear texture 23 is different, which can be understood as: defining any first-level area A and first-level area B as any two adjacent first-level areas, the first-level area A includes multiple texture units A, the first linear texture 22 within the multiple texture units A extends in the a direction, and the second linear texture 23 extends in the b direction; the first-level area B includes multiple texture units b, the first linear texture 22 within the multiple texture units b extends in the c direction, the second linear texture 23 extends in the d direction, and the a, b, c, and d directions are different, to ensure the texture patterns and the light and shadow effects presented between the multiple first-level areas are different, and the same decorative plate 100 includes multiple first-level areas with textures and light and shadow changes at the same time, and the appearance effect is more abundant. In still other specific embodiments, the above situation is that the first-level area A includes multiple texture units A, and the first linear texture 22 within the multiple texture units A extends in the a direction, and the second linear texture 23 extends in the b direction; the first-level area B includes multiple texture units B, the first linear texture 22 within the multiple texture units B extends in a direction, the second linear texture 23 extends in c direction. Alternatively, in some specific embodiments, the first-level area A includes multiple texture units A, and the first linear textures 22 within the multiple texture units A extend in the a direction, and the second linear textures 23 extend in the b direction; the first-level area B includes multiple texture units B, the first linear textures 22 within the multiple texture units B extend in c direction, the second linear textures 23 extend in b direction, etc. Of course, when each texture unit is only provided with the first linear texture 22 inside, the extension direction of the first linear texture sub-segment 221 in the first-level area A and the extension direction of the first linear texture sub-segment 221 in the first-level area B may be different.

At least part of the maximum distances from the first linear textures 22 to the substrate 10 are different and/or the maximum distances from the second linear textures 23 to the substrate 10 are different, and it can be understood that the maximum distance from the first linear texture 22 to the substrate 10 within the texture unit A in the first-level area A is hₐ₁, and the maximum distance from the second linear texture 23 to the substrate 10 is hₐ₂; the maximum distance from the first linear texture 22 to the substrate 10 within the texture unit B in first-level area B is h_{b1}, and the maximum distance from the second linear texture 23 to the substrate 10 is h_{b2}; in some embodiments, hₐ₁ is different from h_{b1}, and/or hₐ₂ is different from h_{b2}. In some specific embodiments of the present disclosure, the difference in the maximum distance to the substrate 10 and the difference in the extension direction described above are combined to make the texture and the light and shadow change effects in different first-level areas more distinctive. Of course, when each texture unit is only provided with the first linear texture 22 inside, the maximum distance from the first linear texture 22 to the substrate 10 is hₐ₁ within the texture unit A in the first-level area A, and the maximum distance from the first linear texture 22 to the substrate 10 is h_{b1} within the texture unit B in the first-level B, and hₐ₁ may be different from h_{b1}.

In some embodiments of the present disclosure, the orthographic projection length of the first linear texture sub-segment 221 and the second linear texture sub-segment 231 on the substrate 10 (that is, the curve width of the first linear texture sub-segment and the second linear texture sub-segment) is each independently in a range of 0.5 mm to 1. 5 mm. The curve width of the first linear texture sub-segment 221 can be understood as a linear distance L between the head end and the tail end of a single first linear texture sub-segment 221 in the extension direction thereof (see FIG. 3), and similarly, the curve width of the second linear texture sub-segment 231 is understood in the same manner as the first linear texture sub-segment 221. For example, the curve widths of the first linear texture sub-segment 221, the second linear texture sub-segment 231 may each independently be 0.5 mm, 0.6 mm, 0.7 mm, 0.8 mm, 0.9 mm, 1.0 mm, 1.1 mm, 1.2 mm, 1.3 mm, 1.4 mm, 1.5 mm, etc. Of course, the above cases also apply when each texture unit 21 is only provided with the first linear texture 22 inside.

In some embodiments of the present disclosure, in at least part of the texture units, in the respective extension directions of the first linear texture 22 and the second linear texture 23, the orthographic projection length of the single first linear texture sub-segment 221 and the single second linear texture sub-segment 231 on the substrate 10 gradually changes. The "gradually changes" may be gradually increasing or gradually decreasing. Taking the first linear texture 22 as an example, see FIG. 3, in the extension direction of the first linear texture 22, the orthographic projection length of each first linear texture sub-segment 221 on the substrate 10 gradually decreases, that is, L1 > L2 > L3 > L4 > L5 > L6. In the present disclosure, the orthographic projection length change trend of each sub-segment of the first linear texture 22 on the substrate 10 within the single texture unit and the orthographic projection length change trend of each sub-segment of the second linear texture 23 on the substrate 10 may be the same or different. Of course, the above cases also apply when each texture unit 21 is only provided with the first linear texture 22 inside.

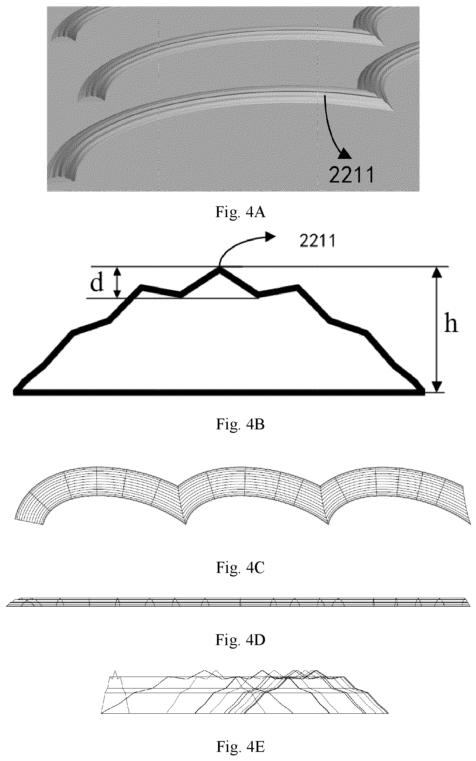

Referring to FIGS. 4A to 4B, in some embodiments of the present disclosure, the surface of each first linear texture sub-segment 221 is provided with multiple strip textures 2211. In some specific embodiments, the extension direction of the strip texture 2211 is basically the same as the outline of the first linear texture sub-segment 221, and it can be understood that a line shaped linear texture sub-segment is provided, multiple linear strip textures 2211 arranged in parallel are arranged on the surface of the linear texture sub-segment, and each strip texture 2211 extends from the head end to the tail end of the linear texture sub-segment, and the each strip texture 2211 may be arranged continuously or at intervals. Then, the entire linear texture sub-segment is bent to obtain the first linear texture sub-segment 221. Furthermore, the relative positions of each strip texture 2211 on the surface of the first linear texture sub-segment 221 are different, so that the each strip texture 2211 has different reflection and scattering capabilities to the same light source, and then the each first linear texture sub-segment 221 can exhibit rich light and shadow effects, so that the decorative plate 100 can exhibit more gorgeous light and shadow effects. Of course, the above changes also apply when each texture unit 21 is only provided with the first linear texture 22 inside.

In the present disclosure, the cross-sectional shape of the strip texture 2211 may be a triangle, an arch, an arc, a trapezoid, etc, and the cross-sectional width of each strip texture 2211 gradually decreases from the bottom surface of the strip texture 2211 in the height direction thereof.

In some embodiments of the present disclosure, the number of the strip textures 2211 on the single first linear texture sub-segment 221 and the single second linear texture sub-segment 231 is 5 to 20. At this time, the light and shadow effects of the single linear texture are relatively abundant, and when the number of strip textures 2211 on the surfaces of the first and second linear texture sub-segments is sufficiently large, the decorative plate 100 can have a colorful effect. Of course, the above cases also apply when each texture unit is only provided with the first linear texture 22 inside.

In some embodiments of the present disclosure, the absolute height of the strip texture 2211 is 5% to 15% of the maximum distance from the corresponding linear texture sub-segment to the substrate 10. Referring to FIG. 4B, the absolute height of the strip texture 2211 refers to the height d of the strip texture 2211 itself. For example, the absolute height of the strip texture 2211 may be 5%, 6%, 7%, 8%, 9%, 10%, 11%, 12%, 13%, 14%, 15%, etc. of the maximum height of the cross-section of the corresponding linear texture sub-segment. Of course, the above cases also apply when each texture unit is only provided with the first linear texture 22 inside.

In the present disclosure, the curvature of the first linear texture sub-segment 221 and the curvature of the second linear texture sub-segment 231 may be the same or different. In different first-level areas, the curvatures of the first and second linear texture sub-segments in the first-level area A and the curvatures of the first and second linear texture sub-segments in the first-level area B may be the same or different. In some specific embodiments, there are some first-level area A and first-level area B, the curvature of the first linear texture sub-segment in the first-level area A is different from that of the first-level area B, and/or the curvature of the second linear texture sub-segment in the first-level area A is different from that of the first-level area B. Of course, when each texture unit is only provided with the first linear texture 22 inside, the curvature of the first linear texture sub-segment 221 in the first-level area A and the curvature of the first linear texture sub-segment 221 in the first-level area B may be different. In some cases, the change in curvature, the change in height, and the change in extension direction described above can be organically combined to enrich the texture and the light and shadow changes of the decorative plate 100.

In some embodiments of the present disclosure, the width of the orthographic projection of the first linear texture sub-segment 221 and the second linear texture sub-segment 231 on the substrate 10 is each independently between 30 µm and 60 µm. For example, the width of the orthographic projection of the first linear texture sub-segment 221, the second linear texture sub-segment 231 on the substrate 10 may each independently be 30 µm, 35 µm, 40 µm, 45 µm, 50 µm, 55 µm, 60 µm, etc. Of course, the above cases also apply when each texture unit is only provided with the first linear texture 22 inside.

In some embodiments of the present disclosure, the spacing between any two adjacent first linear textures 22 and any two adjacent second linear textures 23 is each independently between 60 µm and 120 µm. For example, the spacing between any two adjacent first linear textures 22 and between any two adjacent second linear textures 23 may each independently be 60 µm, 70 µm, 80 µm, 90 µm, 100 µm, 110 µm, 120 µm, 130 µm, 140 µm, 150 µm, etc. At this time, the density of linear texture sub-segments in the single first and second thin light column is more appropriate, and the light and shadow effects are more obvious. Of course, the above cases also apply when each texture unit is only provided with the first linear texture 22 inside.

In some embodiments of the present disclosure, the decorative plate further includes a modification layer, the modification layer includes one or more of a color developing layer, a frosted layer, and a glitter layer, and the modification layer is arranged on the surface of the texture layer and/or the substrate. In some specific embodiments, for example, when the material of the substrate is glass, a coating layer is provided on the surface of the side of the substrate without the texture layer, and an ink layer is superimposed on the surface of the coating layer, to ensure the glass has the effect of light and shadow flow.

In the present disclosure, the material of the substrate is not limited, and metal, glass, polymer composite material, or the like may be used.

In the present disclosure, the preparation method of the texture layer includes one or more of etching, UV transfer printing, and hot press molding. In some embodiments, the substrate includes a transparent film sheet, for example, the substrate may be a polyester substrate (PET film), a polycarbonate substrate (PC film), a polymethyl methacrylate substrate (PMMA film), or a PC/PMMA composite sheet, and the preparation method of the decorative plate includes: making a texture master having a texture pattern on a mold according to the pattern of the texture layer, and transferring the texture master to the surface of the substrate to obtain the decorative plate. In some embodiments, the substrate includes a plastic sheet, and the preparation method of the decorative plate includes: transferring the textured master to the surface of the substrate, and forming the decorative plate by hot press molding, and the obtained decorative plate is a textured plastic sheet. In some embodiments, the substrate includes glass, and the preparation method of the decorative plate includes: preparing a mask plate on the surface of the substrate according to the pattern of the texture layer, etching the substrate, the etching effect is stronger at a thinner part of the mask plate, and the etching effect is weaker at a thicker part of the mask plate, thereby forming a texture pattern on the surface of the substrate to obtain the decorative plate, and the obtained decorative plate is textured glass. The preparation method of the decorative plate provided by the present disclosure has mature technology, simple processing and high stability of the produced product, thereby improving the yield rate of the product and being suitable for mass production.

The embodiment of the present disclosure also provides a cover plate, including the decorative plate provided by the embodiment of the present disclosure and the substrate, wherein the decorative plate is arranged on the surface of the substrate. Wherein, the substrate is used to improve the structural strength of the cover plate, and the substrate may be one or more of plastic, metal, ceramic and glass. The cover plate can present the delicate effect of light and shadow flow, thus greatly improving the aesthetic appearance and having good marketing prospects. In some embodiments of the present disclosure, the cover plate can be used for the housing of the communication device, and the cover plate has a unique appearance, which can improve the recognition of the product.

The embodiment of the present disclosure also provides an electronic device, including the cover plate provided by the embodiment of the present disclosure. In the embodiment of the present disclosure, the electronic device may be specifically a mobile phone, a computer, a USB flash drive, an electronic cigarette, a wearable device such as a watch, a digital camera, etc.

The above is an exemplary embodiment of the present disclosure, and it should be pointed out that for those skilled in the art, some improvements and retouches can be made to the present disclosure without departing from the principles of the present disclosure, and these improvements and retouches are also regarded as the scope of protection of the present disclosure.

## Claims

1. A decorative plate (100), comprising a substrate (10) and a texture layer (20) arranged on the substrate (10); the texture layer (20) comprising multiple texture units (21), the multiple texture units (21) comprising multiple first linear textures (22) spaced apart in a first direction, each first linear texture (22) comprising, in an extension direction thereof, connected multiple first linear texture sub-segments (221), the multiple first linear texture sub-segments (221) are bent in the same direction in a plane where the texture layer (20) is located, and the bending direction is different from the extension direction of the first linear texture (22); the extension direction of the first linear texture (22) is different from the first direction.

2. The decorative plate (100) according to claim 1, wherein continuous multiple adjacent first linear texture sub-segments (221) form a single first thin light column in the first direction.

3. The decorative plate (100) according to claim 1, wherein the texture unit (21) further comprises multiple second linear textures (23) spaced apart in a second direction, each second linear texture (23) comprises, in an extension direction thereof, multiple connected second linear texture sub-segments (231) , the multiple second linear texture sub-segments (231) are bent in the same direction in a plane where the texture layer (20) is located, and the bending direction is different from the extension direction of the second linear texture (23); the extension direction of the second linear texture (23) is different from the second direction;
the second direction is different from the first direction, and the extension direction of the first linear texture (22) is different from the extension direction of the second linear texture (23);
the first linear texture sub-segment (221) intersects the second linear texture sub-segment (231).

4. The decorative plate (100) according to claim 3, wherein continuous multiple adjacent second linear texture sub-segments (231) form a single second thin light column in the second direction.

5. The decorative plate (100) according to claim 3, wherein the first linear texture sub-segment (221) is bent in the first direction; and/or the second linear texture sub-segment (231) is bent in the second direction.

6. The decorative plate (100) according to claim 3, wherein the first linear texture (22) and/or the second linear texture (23) is wavy.

7. The decorative plate (100) according to any one of claims 3 to 5, wherein the surface of at least part of the first linear texture sub-segments (221) further comprises multiple strip textures (2211); and/or the surface of at least part of the second linear texture sub-segments (231) further comprises multiple strip textures (2211).

8. The decorative plate (100) according to any one of claims 3 to 5, wherein the angle between the extension direction of the first linear texture (22) and the extension direction of the second linear texture (23) is in the range of 80 ° to 100 °.

9. The decorative plate (100) according to any one of claims 3 to 5, wherein multiple first linear texture sub-segments (221) of the multiple first linear textures (22) are spaced apart in the first direction, and adjacent end points of the multiple first linear texture sub-segments (221) arranged in the first direction are connected to form a straight line or curve; and/or multiple second linear texture sub-segments (231) of the second linear texture (23) are spaced apart in the second direction, and adjacent end points of the multiple second linear texture sub-segments (231) arranged in the second direction are connected to form a straight line or a curve.

10. The decorative plate (100) according to any one of claims 3 to 5, wherein the maximum distance from the first linear texture sub-segment (221) to the substrate (10) is 0.5 µm to 20 µm, and the maximum distance from the second linear texture sub-segment (231) to the substrate (10) is 0.5 µm to 20 µm.

11. The decorative plate (100) according to any one of claims 3 to 5, wherein in at least part of the texture units (21), the maximum distance from the each first linear texture sub-segments (221) to the substrate (10) gradually varies in the extension direction of the first linear texture (22); and/or the maximum distance from the each second linear texture sub-segments (231) to the substrate (10) gradually varies in the extension direction of the second linear texture (23).

12. The decorative plate (100) according to any one of claims 3 to 5, wherein in at least part of the texture units (21), the maximum distance from the multiple first linear textures (22) to the substrate (10) gradually varies in the first direction; and/or the maximum distance from the multiple second linear textures (23) to the substrate (10) gradually varies in the second direction.

13. The decorative plate (100) according to any one of claims 3 to 5, wherein in at least part of the texture units (21), the maximum distance from the multiple the first linear texture sub-segments (221) to the substrate (10) gradually increases firstly and then gradually decreases, or gradually decreases firstly and then gradually increases in the extension direction of the first linear texture sub-segments (221);
and/or the maximum distance from the multiple second linear texture sub-segments (231) to the substrate (10) gradually increases firstly and then gradually decreases, or gradually decreases firstly and then gradually increases in the extension direction of the second linear texture sub-segments (231).

14. The decorative plate (100) according to any one of claims 3 to 5, wherein in at least part of the texture units (21), the maximum distance from the first linear texture (22) and the second linear texture (23) to the substrate (10) within a single texture unit (21) is different.

15. The decorative plate (100) according to any one of claims 3 to 5, wherein the texture layer (20) comprises multiple primary areas (A, B), at least part of the primary areas (A, B) comprises at least one texture unit (21), the extension direction of the first linear texture (22) between the multiple primary area (A, B) is different and/or the extension direction of the second linear texture (23) between the multiple primary area (A, B) is different;
and/or at least part of the maximum distances from the first linear textures (22) to the substrate (10) are different and/or the maximum distances from the second linear textures (23) to the substrate (10) are different.

16. The decorative plate (100) according to any one of claims 3 to 5, wherein the length of the orthographic projection of the first linear texture sub-segment (221), the second linear texture sub-segment (231) on the substrate (10) is each independently in the range of 0.5 mm to 1.5 mm; the width of the orthographic projection of the first linear texture sub-segment (221) and the second linear texture sub-segment (231) on the substrate (10) is each independently in the range of 30 µm to 60 µm.

17. The decorative plate (100) according to any one of claims 3 to 5, wherein in at least part of the texture units (21), the length of the orthographic projection of the single first linear texture sub-segments (221), the single second linear texture sub-segments (231) on the substrate (10) gradually varies in the respective extension directions of the first linear texture (22) and the second linear texture (23).

18. The decorative plate (100) according to claim 7, wherein the absolute height of the strip texture (2211) is 5% to 15% of the maximum distance from the corresponding linear texture sub-segment to the substrate (10).

19. A cover plate, comprising a substrate and a decorative plate (100) according to any one of claims 1 to 18, the decorative plate being arranged on a surface of the substrate.

20. An electronic device, comprising the cover plate according to claim 19.
